(19) Europäisches Patentamt
European Patent Office
Office européen des brevets

(11) **EP 3 840 113 B1**

(12) **FASCICULE DE BREVET EUROPEEN**

(45) Date de publication et mention
de la délivrance du brevet:
**19.10.2022 Bulletin 2022/42**

(21) Numéro de dépôt: **20211820.4**

(22) Date de dépôt: **04.12.2020**

(51) Classification Internationale des Brevets (IPC):
*H01Q 1/22* *(2006.01)*    *H04B 7/08* *(2006.01)*

(52) Classification Coopérative des Brevets (CPC):
**H01Q 1/22**

(54) **ÉQUIPEMENT ÉLECTRIQUE ADAPTÉ À DÉTECTER LA PRÉSENCE D'UNE ANTENNE EXTERNE**

ELEKTRISCHES GERÄT EINGERICHTET FÜR DIE DETEKTION DER ANWESENHEIT EINER EXTERNEN ANTENNE

ELECTRICAL DEVICE ADAPTED TO THE DETECTION OF THE PRESENCE OF AN EXTERNAL ANTENNA

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2019 FR 1914872**

(43) Date de publication de la demande:
**23.06.2021 Bulletin 2021/25**

(73) Titulaire: **Sagemcom Energy & Telecom SAS
92500 Rueil-Malmaison (FR)**

(72) Inventeurs:
• **KHOURI, Rami
92500 RUEIL MALMAISON (FR)**
• **TISNE, Alain
92500 RUEIL MALMAISON (FR)**

(74) Mandataire: **Lavaud, Thomas et al
Cabinet Boettcher
16, rue Médéric
75017 Paris (FR)**

(56) Documents cités:
WO-A1-2013/089553     WO-A1-2019/162432
WO-A2-2005/094154     US-A1- 2018 287 657

**Description**

L'invention concerne le domaine des équipements électriques comprenant un module radio susceptible de fonctionner avec une antenne interne ou avec une antenne externe si une telle antenne externe est connectée à l'équipement électrique.

ARRIERE PLAN DE L'INVENTION

Certains équipements électriques, et, en particulier, certains compteurs communicants et certaines passerelles, comportent un module radio susceptible de fonctionner soit avec une antenne interne intégrée dans l'équipement électrique, soit avec une antenne externe ajoutée à l'équipement électrique et connectée à un connecteur externe de l'équipement électrique prévu à cet effet.

Le module radio est par exemple un module radio cellulaire, et le connecteur externe est par exemple un connecteur coaxial.

L'utilisation de l'antenne externe permet d'améliorer la réception et la transmission de données par l'équipement électrique. Ainsi, par exemple, lorsqu'un compteur électrique doit être installé dans une zone faiblement couverte par le réseau cellulaire, par exemple dans une cave, on connecte une antenne externe au compteur électrique pour lui permettre de transmettre des données montantes et de recevoir des données descendantes plus efficacement.

Il convient donc de détecter la présence d'une antenne externe connectée sur le connecteur externe de l'équipement électrique, de manière à pouvoir relier le module radio à l'antenne externe lorsque celle-ci est présente.

Les solutions connues de l'art antérieur pour détecter la présence d'une antenne externe connectée à un connecteur externe de type connecteur coaxial sont les suivantes.

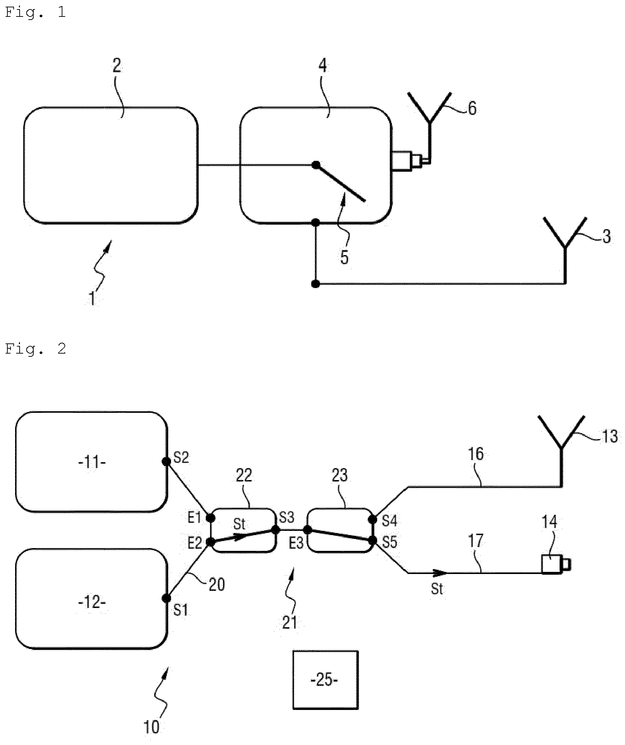

Une solution « mécanique » est visible sur la figure 1. Un équipement électrique 1 comprend un module radio cellulaire 2, une antenne interne 3, et un connecteur coaxial 4 (par exemple un connecteur SMA) dans lequel est intégré un interrupteur 5. C'est le connecteur coaxial 4 qui détecte mécaniquement la connexion d'une antenne externe 6 ou d'un câble auquel est connectée l'antenne externe 6.

Dans une solution « optique « », un lien optique disposé en aval du connecteur coaxial détecte l'obstruction causée par l'introduction de l'antenne externe ou d'un câble auquel est connectée l'antenne externe.

Dans une solution « électrique », un signal DC est interrompu par la présence d'une antenne externe équipée d'une résistance DC.

Dans une solution de « radio en émission », on active l'émission sur le module radio et on mesure la réflexion du signal émis.

Dans une solution de « radio en réception », on compare les puissances des signaux reçus sur les deux voies du module radio, c'est à dire sur la voie comprenant l'antenne interne et sur la voie comprenant le connecteur coaxial.

Les demandes de brevet WO 2005/094154 A2, WO 2013/089553 A1, US 2018/287657 A1 et WO 2019/162432 A1 divulguent de telles solutions.

Les problèmes posés par ces techniques de détection sont les suivants.

La solution « mécanique » nécessite des connecteurs coaxiaux spéciaux, volumineux, chers (environ trois fois le prix d'un connecteur coaxial classique) et difficiles à intégrer sur un circuit imprimé. Le principal inconvénient fonctionnel de cette solution est l'apparition d'un bagotement mécanique en cas de serrage défaillant de l'antenne externe ou du câble relié au connecteur coaxial. De plus, dans le cas de la présence d'un câble coaxial, il est impossible de détecter la présence d'une antenne au bout du câble coaxial. Malgré les défauts de robustesse précités, cette méthode reste la plus simple, et elle est très utilisée dès lors que le module radio est de type cellulaire.

La solution « optique » n'est pas robuste à cause d'éléments pouvant obstruer la liaison optique (la poussière par exemple).

La solution « électrique » nécessite comme on l'a vu l'utilisation d'antennes externes spéciales, équipées d'une résistance DC, ce qui limite grandement le choix des antennes externes.

La solution de « radio en émission » est aujourd'hui la technique la plus fiable. Cependant, cette solution n'est pas applicable dans le cas d'un module radio cellulaire. En effet, l'émission d'un signal continu n'est permise qu'en mode « test », ce qui est impossible à mettre en place sur le terrain. Le fait d'attendre une émission signalisée standard (c'est-à-dire conforme au protocole 3GPP et aux normes radio) peut prendre beaucoup de temps (jusqu'à 1 heure s'il faut balayer plusieurs technologies comme la 2G, 3G et la 4G par exemple).

La solution de « radio en réception » est peu fiable car elle dépend fortement des conditions extérieures (qualité du réseau, bruits passagers, environnement immédiat de l'équipement électrique, etc.).

OBJET DE L'INVENTION

L'invention a pour objet une solution permettant de détecter la connexion d'une antenne externe à un équipement électrique tel que précédemment décrit, ladite solution ne présentant pas les inconvénients qui viennent d'être évoqués.

RESUME DE L'INVENTION

En vue de la réalisation de ce but, on propose un équipement électrique comprenant :

- une antenne interne ;

- un connecteur externe configuré pour être connecté à une antenne externe à l'équipement électrique ;
- un premier module radio ;
- un deuxième module radio ; chaque module radio étant agencé pour mettre en œuvre une communication via une transmission radio,
- un lien radiofréquence reliant le deuxième module radio au connecteur externe ;
- un dispositif de détection agencé pour, lorsqu'un signal de test est émis sur le connecteur externe via le lien radiofréquence, produire un signal de détection représentatif de la connexion ou non de l'antenne externe au connecteur externe ;
- des moyens de commande agencés pour piloter le deuxième module radio de sorte que celui-ci génère et émette le signal de test via le lien radiofréquence, pour acquérir le signal de détection, et, selon le signal de détection, pour connecter le premier module radio au connecteur externe si l'antenne externe est connectée au connecteur externe, et pour connecter le premier module radio à l'antenne interne si l'antenne externe n'est pas connectée au connecteur externe.

Ainsi, dans l'équipement électrique selon l'invention, on ajoute un lien radiofréquence supplémentaire permettant de relier le deuxième module radio au connecteur externe, et on tire profit de la présence du deuxième module radio pour détecter qu'une antenne externe, destinée à être connectée au premier module radio, est connectée ou non au connecteur externe.

La solution de l'invention est très avantageuse.

En effet, la solution de l'invention peut être mise en œuvre avec un connecteur externe classique et ne présente donc pas les problèmes liés au connecteur spécial de la solution « mécanique » précédemment décrite. Par ailleurs, la détection mise en œuvre grâce au signal de test et au signal de détection permet de détecter, lorsqu'un câble est connecté au connecteur externe, si une antenne externe est connectée ou non à l'autre extrémité du câble.

La solution de l'invention est robuste et ne peut être perturbée par de la poussière.

La solution de l'invention peut être mise en œuvre quel que soit le type d'antenne externe utilisée.

Dans le cas où le premier module radio est un module radio cellulaire et où le deuxième module radio est un module radio de type ISM (pour Industriel, Scientifique et Médical), la solution de l'invention ne présente pas les difficultés de mise en œuvre de la solution de « radio en émission ». En effet, il est possible d'émettre à tout moment un signal de test depuis un module radio ISM, à condition bien sûr que les normes ISM soient respectées.

Enfin, la solution de l'invention est mise en œuvre entièrement à l'intérieur de l'équipement électrique et n'est pas perturbée par les conditions extérieures.

On propose de plus un équipement électrique tel que celui qui vient d'être décrit, dans lequel le lien radiofréquence est un lien conduit.

On propose de plus un équipement électrique tel que celui qui vient d'être décrit, dans lequel le lien radiofréquence est un lien rayonné, le dispositif de détection comprenant une antenne de liaison reliée par le lien radiofréquence à une antenne de communication du deuxième module radio.

On propose en outre un équipement électrique tel que celui qui vient d'être décrit, comportant une ligne radiofréquence principale comprenant une piste radiofréquence principale reliée au connecteur externe, le dispositif de détection comprenant une ligne radiofréquence de détection comprenant une piste radiofréquence de détection couplée à la piste radiofréquence principale, et des composants de détection reliés à la piste radiofréquence de détection.

On propose de plus un équipement électrique tel que celui qui vient d'être décrit, dans lequel les composants de détection comprennent des premiers composants de détection reliés à une première extrémité de la piste radiofréquence de détection et agencés pour produire une première tension représentative d'une puissance directe résultant directement de l'émission du signal de test, des deuxièmes composants de détection reliés à une deuxième extrémité de la piste radiofréquence de détection et agencés pour produire une deuxième tension représentative d'une puissance réfléchie résultant d'une réflexion du signal de test, le signal de détection étant obtenu à partir de la première tension et de la deuxième tension.

On propose de plus un équipement électrique tel que celui qui vient d'être décrit, dans lequel les premiers (respectivement les deuxièmes) composants de détection comprennent un premier (resp. un deuxième) circuit élévateur de tension suivi d'une première (resp. d'une deuxième) diode de détection de crête.

On propose de plus un équipement électrique tel que celui qui vient d'être décrit, dans lequel la ligne radiofréquence principale est une ligne large bande alors que la ligne radiofréquence de détection est une ligne sélective accordée à une fréquence de test du signal de test.

On propose de plus un équipement électrique tel que celui qui vient d'être décrit, comprenant un dispositif de commutation, les moyens de commande étant agencés pour piloter le dispositif de commutation de manière à connecter ou à déconnecter sélectivement le deuxième module radio du connecteur externe, et de manière à connecter sélectivement le premier module radio à la première antenne interne ou au connecteur externe.

On propose de plus un équipement électrique tel que celui qui vient d'être décrit, dans lequel le dispositif de commutation comporte un premier commutateur deux voies et un deuxième commutateur deux voies, le premier commutateur deux voies ayant une première entrée reliée à une sortie du premier module radio, une deuxième entrée reliée à une sortie du deuxième module radio via le lien radiofréquence, le deuxième commutateur deux voies ayant une entrée reliée à une sortie du premier commutateur deux voies, une première sortie reliée à l'antenne interne et une deuxième sortie reliée au connecteur externe.

On propose de plus un équipement électrique tel que celui qui vient d'être décrit, dans lequel une fréquence de test du signal de test est incluse dans une bande de fréquence dans laquelle fonctionne le premier module radio.

On propose de plus un équipement électrique tel que celui qui vient d'être décrit, dans lequel le signal de test est codé de manière à éviter qu'un signal parasite à la fréquence de test ne perturbe le dispositif de détection.

On propose de plus un équipement électrique tel que celui qui vient d'être décrit, dans lequel le premier module radio est un module radio cellulaire et dans lequel le deuxième module radio est un module radio ISM.

On propose de plus un équipement électrique tel que celui qui vient d'être décrit, l'équipement électrique étant un compteur.

On propose de plus un équipement électrique tel que celui qui vient d'être décrit, l'équipement électrique étant une passerelle.

On propose en outre un procédé de détection et de connexion d'antenne externe mis en œuvre dans un équipement électrique selon l'une des revendications précédentes, comprenant les étapes de :

- piloter le deuxième module radio de sorte que celui-ci génère et émette le signal de test sur le connecteur externe via le lien radiofréquence ;
- acquérir le signal de détection ;
- déduire du signal de détection si l'antenne externe est connectée ou non au connecteur externe ;
- si l'antenne externe est connectée au connecteur externe, connecter le premier module radio au connecteur ;
- sinon, connecter le premier module radio à l'antenne interne.

On propose aussi un programme d'ordinateur comprenant des instructions qui conduisent l'équipement électrique tel que précédemment décrit à exécuter les étapes du procédé de détection et de connexion d'antenne externe qui vient d'être décrit.

On propose en outre un support d'enregistrement lisible par ordinateur, sur lequel est enregistré le programme d'ordinateur qui vient d'être décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés, parmi lesquels :

[Fig. 1] la figure 1 représente une solution « mécanique » de l'art antérieur pour détecter la présence d'une antenne externe ;
[Fig. 2] la figure 2 représente un équipement électrique selon un premier mode de réalisation de l'invention ;
[Fig. 3] la figure 3 représente aussi l'équipement électrique selon le premier mode de réalisation de l'invention ;
[Fig. 4] la figure 4 représente de manière simplifiée un dispositif de détection ;
[Fig. 5] la figure 5 représente de manière plus précise le dispositif de détection ;
[Fig. 6] la figure 6 est une vue en perspective d'une portion de carte électrique comprenant le dispositif de détection et un connecteur coaxial ;
[Fig. 7] la figure 7 représente des étapes d'un procédé de détection et de connexion ;
[Fig. 8] la figure 8 est un graphique comprenant une courbe d'une puissance directe, une courbe d'une puissance réfléchie et une courbe d'une puissance mesurée sur une piste radiofréquence principale, les courbes étant obtenues alors qu'une antenne externe est connectée ;
[Fig. 9] la figure 9 est un graphique similaire à celui de la figure 8, les courbes étant obtenues alors que l'antenne externe n'est pas connectée ;

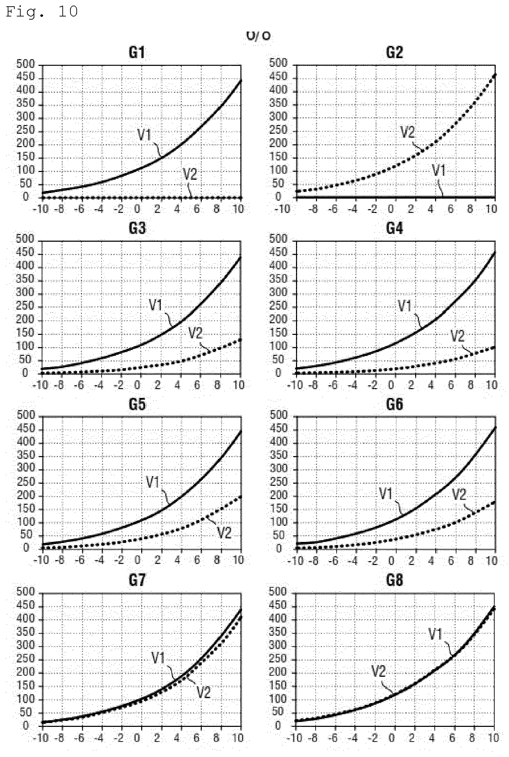

[Fig. 10] la figure 10 comporte des graphiques comprenant chacun une courbe d'une première tension et une courbe d'une deuxième tension, les courbes étant obtenues par simulation avec des TOS et des impédances différentes ;
[Fig. 11] la figure 11 est un tableau de valeurs ayant permis d'obtenir les courbes de la figure 10 ;
[Fig. 12] la figure 12 représente l'équipement électrique selon un deuxième mode de réalisation de l'invention.

DESCRIPTION DETAILLEE DE L'INVENTION

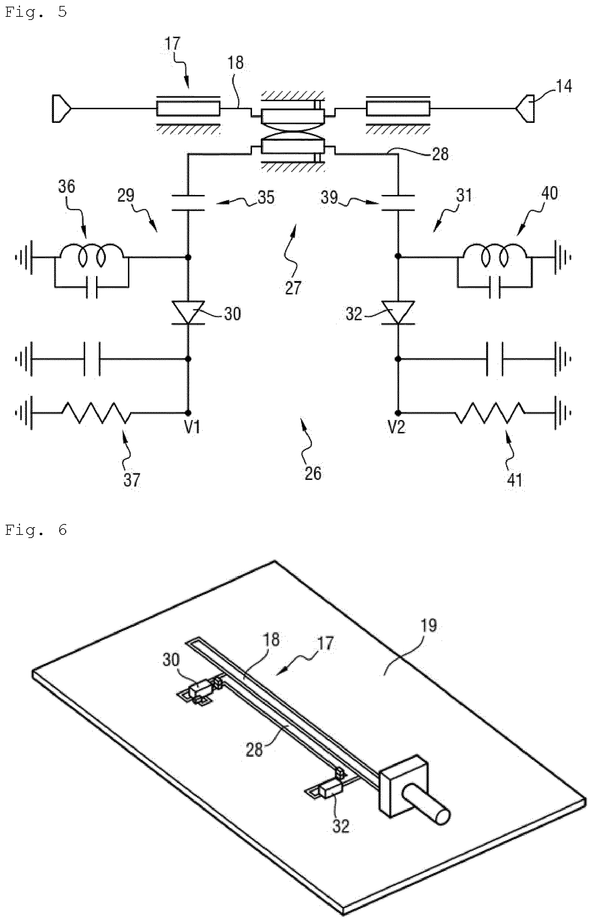

En référence aux figures 2 à 6, un équipement électrique selon un premier mode de réalisation de l'invention est ici un compteur électrique 10 qui comporte un boîtier dans lequel sont intégrés un premier module radio 11 et un deuxième module radio 12.

Ici, par « module radio », on entend un module agencé pour mettre en œuvre une communication (émission et/ou réception) via une transmission radio.

Le premier module radio 11 est un module radio cellulaire susceptible de communiquer en utilisant toutes ou certaines des normes suivantes : 2G, 3G, 4G, Cat-M, NB-IOT, etc.

Le deuxième module radio 12 est un module radio ISM. Ici, le deuxième module radio 12 fonctionne à une fréquence ISM de 868,3MHz.

Le compteur 10 comprend une antenne interne 13 située dans le boîtier, et un connecteur externe, en l'occurrence un connecteur coaxial 14, qui permet de connecter au compteur 10 une antenne externe.

On note que l'antenne externe peut être connectée directement sur le connecteur coaxial 14 ou bien via un câble qui comprend alors une première extrémité à laquelle est connectée l'antenne externe et une deuxième extrémité connectée au connecteur coaxial 4.

Le compteur 10 comprend une première ligne radiofréquence principale 16 qui permet de relier le premier module radio 11 à l'antenne interne 13, et une deuxième ligne radiofréquence principale 17 qui permet de relier le deuxième module radio 12 au connecteur axial 14.

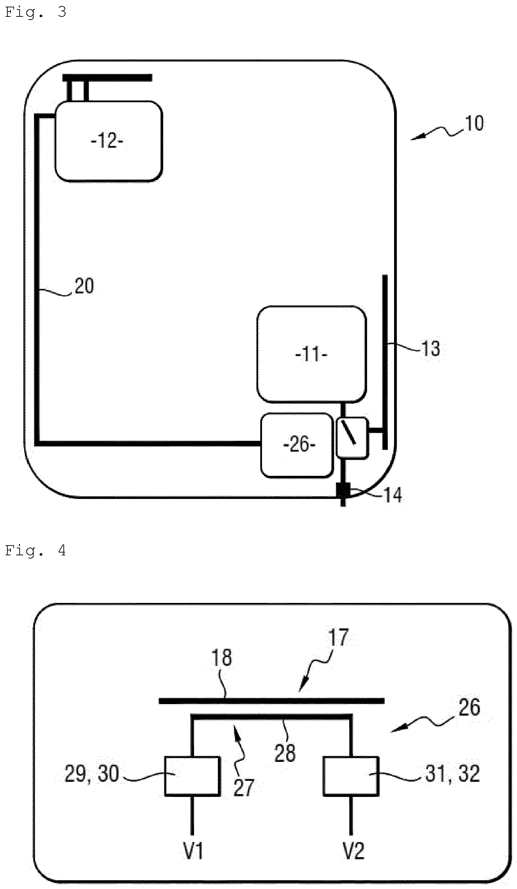

La deuxième ligne radiofréquence principale 17 est mieux visible sur les figures 4 à 6. On voit que la deuxième ligne radiofréquence principale 17 comprend une piste radiofréquence principale 18. La piste radiofréquence principale 18 est une piste de cuivre formée sur une face d'une portion d'une carte électrique. Le reste de la face de la portion de carte électrique est majoritairement recouverte par une surface de cuivre 19 formant un plan de masse, de sorte que la piste radiofréquence principale 18 s'étend dans ledit plan de masse 19 en étant isolée de celui-ci par de fines bandes de substrat non recouvertes de cuivre.

Le compteur 10 comporte aussi un lien radiofréquence 20 qui permet de relier une sortie S1 du deuxième module radio 12 au connecteur coaxial 14. Ici, le lien radiofréquence 20 est un lien conduit qui comprend une piste radiofréquence ou un câble radiofréquence.

Le compteur 10 comporte aussi un dispositif de commutation 21 qui comprend un premier commutateur deux voies 22 et un deuxième commutateur deux voies 23. Le premier commutateur deux voies 22 a une première entrée E1 reliée à une sortie S2 du premier module radio 11, une deuxième entrée E2 reliée à la sortie S1 du deuxième module radio 12 via le lien radiofréquence 20, et une sortie S3. Le deuxième commutateur deux voies 23 a une entrée E3 reliée à la sortie S3 du premier commutateur deux voies 22, une première sortie S4 reliée à l'antenne interne 13 via la première ligne radiofréquence principale 16 et une deuxième sortie S5 reliée au connecteur coaxial 14 via la deuxième ligne radiofréquence principale 17.

Le compteur 10 comprend de plus des moyens de commande comprenant ici un composant de commande 25 adapté à exécuter des instructions d'un programme pour mettre en œuvre les étapes du procédé de détection et de connexion d'antenne externe qui vont être décrites. Le composant de commande 25 est par exemple un microcontrôleur, un processeur, ou bien un circuit logique programmable tel qu'un FPGA (pour *Field Programmable Gate Arrays)* ou un ASIC (pour *Application Specific Integrated Circuit*).

Le composant de commande 25 est relié au premier commutateur deux voies 22 et au deuxième commutateur deux voies 23 et est agencé pour les piloter, c'est-à-dire pour relier sélectivement la première entrée E1 ou la deuxième entrée E2 du premier commutateur deux voies 22 à la sortie S3 du premier commutateur deux voies 22, et pour relier sélectivement l'entrée E3 du deuxième commutateur deux voies 23 à la première sortie S4 ou à la deuxième sortie S5 du deuxième commutateur deux voies 23.

Le compteur 10 comporte de plus un dispositif de détection 26, mieux visible sur les figures 4 à 6. Le dispositif de détection 26 comprend un circuit coupleurdétecteur comportant une ligne radiofréquence de détection 27 comprenant une piste radiofréquence de détection 28 couplée à la piste radiofréquence principale 18, et des composants de détection reliés à la piste radiofréquence de détection 28.

Les composants de détection comprennent des premiers composants de détection reliés à une première extrémité de la piste radiofréquence de détection 28, et des deuxièmes composants de détection reliés à une deuxième extrémité de la piste radiofréquence de détection 28.

Les premiers composants de détection comprennent un premier circuit élévateur de tension 29 suivi d'une première diode de détection de crête 30, ainsi qu'un réseau R-C 37. Les deuxièmes composants de détection comprennent un deuxième circuit élévateur de tension 31 suivi d'une deuxième diode de détection de crête 32, ainsi qu'un réseau R-C 41.

Le premier circuit élévateur de tension 29 comprend un premier condensateur 35 relié à la première extrémité de la piste radiofréquence de détection 28 et un premier circuit LC 36 auquel est connectée la première diode de détection de crête 30. De même, le deuxième circuit élévateur de tension 31 comprend un deuxième condensateur 39 relié à la deuxième extrémité de la piste radiofréquence de détection 28 et un deuxième circuit LC 40 auquel est connectée la deuxième diode de détection de crête 32.

La ligne radiofréquence de détection 27, du fait de la présence des premiers composants de détection et des deuxièmes composants de détection, est une ligne sélective accordée sur la fréquence ISM évoquée plus tôt (868,3MHz). Le coupleur-redresseur est donc lui aussi accordé à la fréquence ISM.

La deuxième ligne radiofréquence principale 17, quant à elle, est une ligne large bande.

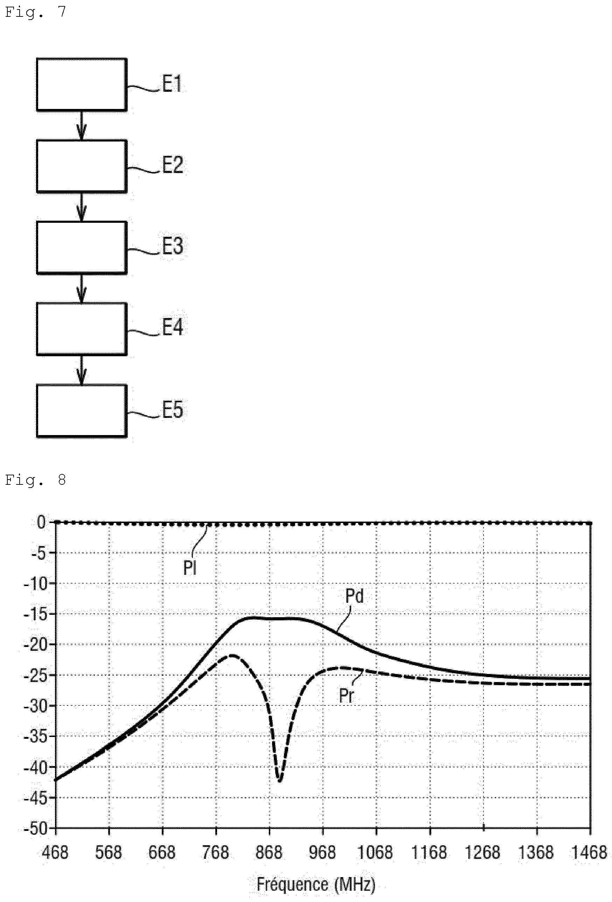

On décrit maintenant plus en détail le procédé de détection et de connexion d'antenne externe mis en œuvre dans le compteur 10. L'enchaînement des étapes principales du procédé est visible sur la figure 7.

Par défaut, le premier commutateur deux voies 22 et le deuxième commutateur deux voies 23 se trouvent dans une configuration telle que la sortie S1 du deuxième module radio 12 est reliée au connecteur coaxial 14 (via le lien radiofréquence 20 et la deuxième ligne radiofréquence principale 17 ; étape E1). La deuxième entrée E2 du premier commutateur deux voies 22 est donc reliée à la sortie S3 du premier commutateur deux voies 22, et la deuxième sortie S5 du deuxième commutateur deux voies 23 est reliée à l'entrée E3 du deuxième commutateur deux voies 23 et donc à la deuxième entrée E2 du premier commutateur deux voies 22.

Le composant de commande 25 pilote alors le deuxième module radio 12 de sorte que celui-ci génère et émette un signal de test St sur le connecteur coaxial 14 via le lien radiofréquence 20 (étape E2).

La fréquence de test du signal de test St est la fréquence ISM de 868,3MHz. On note qu'il est préférable que la fréquence de test du signal de test St soit incluse dans la bande de fréquence dans laquelle fonctionne le premier module radio 11, ce qui est bien le cas ici.

Le dispositif de détection 26 produit alors un signal de détection représentatif de la connexion ou non de l'antenne externe au connecteur coaxial 14 (étape E3). Le signal de détection est acquis par le composant de commande 25.

Le signal de détection est ici obtenu à partir d'une première tension V1 produite aux bornes du réseau R-C 37, et d'une deuxième tension V2 produite aux bornes du réseau R-C 41. Le signal de détection est ici en l'occurrence égal à : V2 - V1.

Le composant de commande 25 acquiert, numérise et analyse la première tension V1 et la deuxième tension V2.

La première tension V1 est représentative d'une puissance directe, obtenue au niveau de la première extrémité de la piste radiofréquence de détection 28, et résultant de l'émission directe du signal de test St.

La deuxième tension V2 est représentative d'une puissance réfléchie, obtenue au niveau de la deuxième extrémité de la piste radiofréquence de détection 28, et résultant de la réflexion du signal de test St, en fonction de la configuration, soit sur le connecteur coaxial 14 seulement, soit sur le connecteur coaxial 14 et l'antenne externe (et éventuellement sur le câble relié au connecteur coaxial 14 et à l'antenne externe).

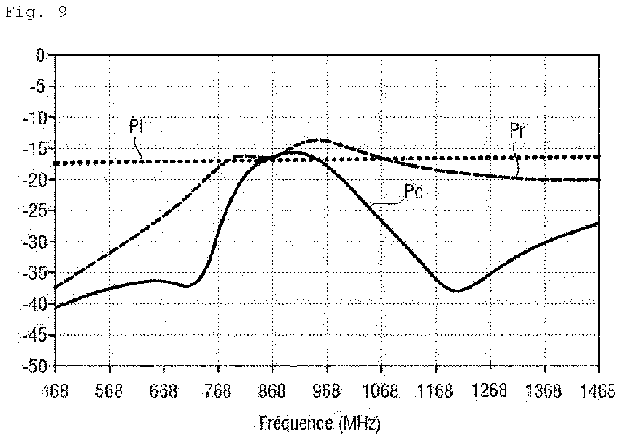

On voit sur la figure 8 que, lorsque l'antenne externe, formant une charge adaptée, est connectée, la puissance directe Pd à la fréquence de test est nettement supérieure à la puissance réfléchie Pr. On voit par contre sur la figure 9 que, lorsque l'antenne externe n'est pas connectée, la puissance directe Pd et la puissance réfléchie Pr sont très proches. Sur les graphiques des figures 8 et 9, la courbe Pl correspond à la puissance détectée sur la piste radiofréquence principale 18.

La différence entre la deuxième tension V2 et la première tension V1 forme donc un signal de détection représentatif de la connexion ou non de l'antenne externe au connecteur coaxial 14.

Le composant de commande 25 compare le signal de détection, c'est-à-dire la différence entre la deuxième tension V2 et la première tension V1, avec un seuil de détection prédéterminé Vseuil.

Si on a :

$$V2-V1 < Vseuil,$$

alors le composant de commande 25 détecte que l'antenne externe n'est pas connectée.

Au contraire, si on a :

$$V2-V1 \geq Vseuil,$$

Alors le composant de commande 25 détecte que l'antenne externe est connectée (étape E4).

Si le composant de commande 25 détecte que l'antenne externe n'est pas connectée, alors le composant de commande 25 pilote le premier commutateur deux voies 22 et le deuxième commutateur deux voies 23 de sorte que la sortie S2 du premier module radio 11 soit connectée à l'antenne interne 13.

Si le composant de commande 25 détecte que l'antenne externe est connectée, alors le composant de commande 25 pilote le premier commutateur deux voies 22 et le deuxième commutateur deux voies 23 de sorte que la sortie S2 du premier module radio 11 soit connectée au connecteur coaxial 14 et donc à l'antenne externe (étape E5).

On note que la détermination de la valeur du seuil de détection prédéterminé Vseuil a été réalisée à partir de mesures effectuées dans plusieurs configurations correspondant chacune à une terminaison possible pour le connecteur coaxial 14.

Dans une première configuration, on a : TOS=1 (TOS, pour Taux d'Ondes Stationnaires), ce qui correspond au Taux D'onde Stationnaire d'une adaptation parfaite de l'antenne externe (charge 50 Ohms).

Dans une deuxième configuration, on a : TOS=2, ce qui correspond au TOS d'une antenne externe bien adaptée (90% du signal est transmis du connecteur coaxial 14 à l'antenne externe).

Dans une troisième configuration, on a : TOS=3, ce qui correspond à une antenne externe de moins bonne qualité (c'est un cas d'utilisation possible car la plupart des antennes externes multi-bandes sont de cet ordre de qualité) .

Dans une quatrième configuration, on a : TOS infini, ce qui correspond au cas d'un circuit-ouvert et donc de l'absence d'une antenne externe. Il est à noter que ce cas est aussi celui dans lequel un câble a sa deuxième extrémité connectée au connecteur coaxial 14 mais n'a pas d'antenne externe connectée à sa première extrémité.

Le seuil détection prédéterminé est optimisé en fonction du type de charge, de manière à ce que même une antenne externe ordinaire (de TOS 3) puisse être détectée facilement.

Avantageusement, le signal de test St est codé par un codage simple, par exemple de type OOK (pour *On-off Keying*) .

On évite de la sorte qu'un signal parasite à la fréquence de test ne perturbe le dispositif de détection 26 et, en particulier, on rend impossible une prise de décision sur la base du signal parasite reçu.

On rend ainsi de la sorte encore plus robuste la discrimination entre les deux états.

On présente maintenant les résultats de simulations réalisées sur le dispositif de détection 26 pour différentes valeurs de TOS et en utilisant différentes valeurs d'impédances.

Le graphique G1 correspond à un cas où le TOS est égal à 1 et où l'impédance au niveau de la deuxième extrémité (reliée au connecteur coaxial 14) de la piste radiofréquence principale 18 est égale à 50Ω. Le graphique G2 correspond à un cas où le TOS est égal à 1 et où l'impédance au niveau de la première extrémité (reliée au dispositif de commutation 21) de la piste radiofréquence principale 18 est égale à 50Ω.

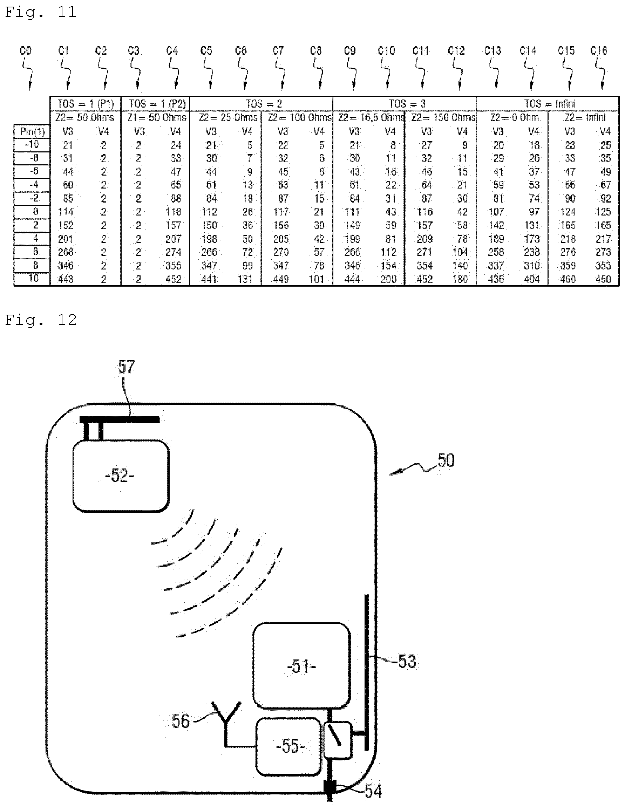

Sur le graphique G1, la courbe de la première tension V1 est obtenue à partir des valeurs de la colonne C1 du tableau de la figure 11. La courbes de la deuxième tension V2 est obtenue à partir des valeurs de la colonne C2 du tableau de la figure 11.

Sur le graphique G2, la courbe de la première tension V1 est obtenue à partir des valeurs de la colonne C3 du tableau de la figure 11. La courbes de la deuxième tension V2 est obtenue à partir des valeurs de la colonne C4 du tableau de la figure 11.

La colonne C0 contient des valeurs (en dB) de puissance détectée sur la deuxième ligne radiofréquence principale 17. Ces valeurs sont rapportées en abscisse dans les différents graphiques.

Le graphique G3 correspond à un cas où le TOS est égal à 2 et où l'impédance au niveau de la deuxième extrémité de la piste radiofréquence principale 18 est égale à 25Ω. Le graphique G4 correspond à un cas où le TOS est égal à 2 et où l'impédance au niveau de la deuxième extrémité de la piste radiofréquence principale 18 est égale à 100Ω.

Sur le graphique G3, la courbe de la première tension V1 est obtenue à partir des valeurs de la colonne C5 du tableau de la figure 11. La courbes de la deuxième tension V2 est obtenue à partir des valeurs de la colonne C6 du tableau de la figure 11.

Sur le graphique G4, la courbe de la première tension V1 est obtenue à partir des valeurs de la colonne C7 du tableau de la figure 11. La courbes de la deuxième tension V2 est obtenue à partir des valeurs de la colonne C8 du tableau de la figure 11.

Le graphique G5 correspond à un cas où le TOS est égal à 3 et où l'impédance au niveau de la deuxième extrémité de la piste radiofréquence principale 18 est égale à 16,5Ω. Le graphique G6 correspond à un cas où le TOS est égal à 3 et où l'impédance au niveau de la deuxième extrémité de la piste radiofréquence principale 18 est égale à 150Ω.

Sur le graphique G5, la courbe de la première tension V1 est obtenue à partir des valeurs de la colonne C9 du tableau de la figure 11. La courbes de la deuxième tension V2 est obtenue à partir des valeurs de la colonne C10 du tableau de la figure 11.

Sur le graphique G6, la courbe de la première tension V1 est obtenue à partir des valeurs de la colonne C11 du tableau de la figure 11. La courbes de la deuxième tension V2 est obtenue à partir des valeurs de la colonne C12 du tableau de la figure 11.

Le graphique G7 correspond à un cas où le TOS est infini et où l'impédance au niveau du la deuxième extrémité de la piste radiofréquence principale 18 est égale à 0Ω. Le graphique G8 correspond à un cas où le TOS est infini et où l'impédance au niveau de la deuxième extrémité de la piste radiofréquence principale 18 est infinie.

Sur le graphique G7, la courbe de la première tension V1 est obtenue à partir des valeurs de la colonne C13 du tableau de la figure 11. La courbes de la deuxième tension V2 est obtenue à partir des valeurs de la colonne C14 du tableau de la figure 11.

Sur le graphique G8, la courbe de la première tension V1 est obtenue à partir des valeurs de la colonne C15 du tableau de la figure 11. La courbes de la deuxième tension V2 est obtenue à partir des valeurs de la colonne C16 du tableau de la figure 11.

On remarque que la différence détectable entre la première tension V1 et la deuxième tension V2 est d'au moins 6 dB (pour une antenne externe médiocre) et de 9 dB pour une antenne externe bien adaptée. Cette différence est largement supérieure au cas où l'antenne externe est absente, ce qui laisse une marge confortable pour définir un seuil de détection prédéterminé Vseuil robuste. La détection de la présence ou de l'absence d'antenne externe est donc à la fois robuste et fiable.

En référence à la figure 12, un équipement électrique selon un deuxième mode de réalisation est à nouveau un compteur électrique 50.

Le compteur électrique 50 comprend un premier module radio 51 (cellulaire), un deuxième module radio 52 (ISM), une antenne interne 53 et un connecteur coaxial 54.

Cette fois, le lien radiofréquence qui permet de relier le deuxième module radio 52 au connecteur coaxial 54 est un lien rayonné. Le dispositif de détection 55 comprend une antenne de liaison 56 reliée par le lien radiofréquence à une antenne de communication 57 du deuxième module radio 52. L'antenne de communication 57 est accordée à la fréquence de test qui est la fréquence ISM du deuxième module radio 52.

Bien entendu, l'invention n'est pas limitée aux modes de réalisation décrits mais englobe toute variante entrant dans le champ de l'invention telle que définie par les revendications.

L'équipement électrique dans lequel est mise en œuvre l'invention n'est pas nécessairement un compteur électrique, mais pourrait être un autre type de compteur, et même un équipement électrique quelconque autre qu'un compteur, par exemple une passerelle (ou *gateway,* en anglais).

On a décrit ici que le composant de commande pilote le deuxième module radio de sorte que celui-ci génère et émette le signal de test via le lien radiofréquence, acquière le signal de détection, et, selon le signal de détection, pilote le dispositif de commutation. Bien sûr, ces opérations pourraient être réalisées par plusieurs composants distincts.

Le premier module radio n'est pas nécessairement un module radio cellulaire, et le deuxième module radio n'est pas nécessairement un module ISM.

## Revendications

1. Equipement électrique comprenant :

   - une antenne interne (13) ;
   - un connecteur externe (14) configuré pour être connecté à une antenne externe à l'équipement électrique (10) ;
   - un premier module radio (11) ;
   - un deuxième module radio (12) ;
   chaque module radio étant agencé pour mettre en œuvre une communication via une transmission radio,
   - un lien radiofréquence (20) reliant le deuxième module radio au connecteur externe ;
   - un dispositif de détection (26) agencé pour, lorsqu'un signal de test (St) est émis sur le connecteur externe via le lien radiofréquence (20), produire un signal de détection représentatif de la connexion ou non de l'antenne externe au connecteur externe ;
   - des moyens de commande (25) agencés pour piloter le deuxième module radio de sorte que celui-ci génère et émette le signal de test via le lien radiofréquence, pour acquérir le signal de détection, et, selon le signal de détection, pour connecter le premier module radio (11) au connecteur externe (14) si l'antenne externe est connectée au connecteur externe, et pour connecter le premier module radio (11) à l'antenne interne (13) si l'antenne externe n'est pas connectée au connecteur externe (14).

2. Equipement électrique selon la revendication 1, dans lequel le lien radiofréquence (20) est un lien conduit.

3. Equipement électrique selon la revendication 1, dans lequel le lien radiofréquence est un lien rayonné, le dispositif de détection (55) comprenant une antenne de liaison (56) reliée par le lien radiofréquence à une antenne de communication (57) du deuxième module radio (52).

4. Equipement électrique selon l'une des revendications précédentes, comportant une ligne radiofréquence principale (17) comprenant une piste radiofréquence principale (18) reliée au connecteur externe (14), le dispositif de détection (26) comprenant une ligne radiofréquence de détection (27) comprenant une piste radiofréquence de détection (28) couplée à la piste radiofréquence principale (18), et des composants de détection reliés à la piste radiofréquence de détection (28).

5. Equipement électrique selon la revendication 4, dans lequel les composants de détection comprennent des premiers composants de détection reliés à une première extrémité de la piste radiofréquence de détection (28) et agencés pour produire une première tension (V1) représentative d'une puissance directe résultant directement de l'émission du signal de test (St), des deuxièmes composants de détection reliés à une deuxième extrémité de la piste radiofréquence de détection (28) et agencés pour produire une deuxième tension (V2) représentative d'une puissance réfléchie résultant d'une réflexion du signal de test (St), le signal de détection étant obtenu à partir de la première tension (V1) et de la deuxième tension (V2).

6. Equipement électrique selon la revendication 5, dans lequel les premiers, respectivement les deuxièmes, composants de détection (29, 31) comprennent un premier, respectivement un deuxième, circuit élévateur de tension suivi d'une première, respectivement d'une deuxième, diode de détection de crête (30, 32).

7. Equipement électrique selon l'une des revendications 4 à 6, dans lequel la ligne radiofréquence principale (17) est une ligne large bande alors que la ligne radiofréquence de détection (27) est une ligne sélective accordée à une fréquence de test du signal de test.

8. Equipement électrique selon l'une des revendications précédentes, comprenant un dispositif de commutation (21), les moyens de commande étant agencés pour piloter le dispositif de commutation de manière à connecter ou à déconnecter sélectivement le deuxième module radio (12) du connecteur externe (14), et de manière à connecter sélectivement le premier module radio (11) à la première antenne interne (13) ou au connecteur externe (14).

9. Equipement électrique selon la revendication 8, dans lequel le dispositif de commutation (21) comporte un premier commutateur deux voies (22) et un deuxième commutateur deux voies (23), le premier commutateur deux voies ayant une première entrée (E1) reliée à une sortie (S2) du premier module radio, une deuxième entrée (E2) reliée à une sortie (S1) du deuxième module radio via le lien radiofréquence (20), le deuxième commutateur deux voies ayant une entrée (E3) reliée à une sortie (S3) du premier commutateur deux voies, une première sortie (S4) reliée à l'antenne interne (13) et une deuxième sortie (S5) reliée au connecteur externe (14).

10. Equipement électrique selon l'une des revendications précédentes, configuré de sorte qu' une fréquence de test du signal de test est incluse dans une bande de fréquence dans laquelle fonctionne le premier module radio (11).

11. Equipement électrique selon l'une des revendications précédentes, configuré de sorte que le signal de test est codé de manière à éviter qu'un signal parasite à la fréquence de test ne perturbe le dispositif de détection (26).

12. Equipement électrique selon l'une des revendications précédentes, dans lequel le premier module radio est un module radio cellulaire et dans lequel le deuxième module radio est un module radio ISM.

13. Equipement électrique selon l'une des revendications précédentes, l'équipement électrique étant un compteur.

14. Equipement électrique selon l'une des revendications 1 à 12, l'équipement électrique étant une passerelle.

15. Procédé de détection et de connexion d'antenne externe mis en œuvre dans un équipement électrique selon l'une des revendications précédentes, comprenant les étapes de :

- piloter le deuxième module radio (12) de sorte que celui-ci génère et émette le signal de test sur le connecteur externe via le lien radiofréquence (20) ;
- acquérir le signal de détection ;
- déduire du signal de détection si l'antenne externe est connectée ou non au connecteur externe ;
- si l'antenne externe est connectée au connecteur externe, connecter le premier module radio au connecteur ;
- sinon, connecter le premier module radio à l'antenne interne.

16. Programme d'ordinateur comprenant des instructions qui conduisent l'équipement électrique selon l'une des revendications 1 à 14 à exécuter les étapes du procédé de détection et de connexion d'antenne externe selon la revendication 15.

17. Support d'enregistrement lisible par ordinateur, sur lequel est enregistré le programme d'ordinateur selon la revendication 16.

**Patentansprüche**

1. Elektrische Ausrüstung, umfassend:

- eine interne Antenne (13);
- einen externen Steckverbinder (14), der ausgebildet ist, um mit einer externen Antenne verbunden zu werden, die sich außerhalb der elektrischen Ausrüstung (10) befindet;
- ein erstes Funkmodul (11);
- ein zweites Funkmodul (12);

wobei jedes Funkmodul ausgebildet ist, um eine Kommunikation über eine Funkübertragung herzustellen,

- eine Hochfrequenzverbindung (20), die das zweite Funkmodul mit dem externen Steckverbinder verbindet;
- eine Detektionsvorrichtung (26), die ausgebildet ist, um, wenn ein Testsignal (St) über die Hochfrequenzverbindung (20) an den externen Steckverbinder gesendet wird, ein Detektionssignal zu erzeugen, das repräsentativ für den Anschluss oder Nichtanschluss der externen Antenne an den externen Steckverbinder ist;
- Steuermittel (25), die ausgebildet sind, um das zweite Funkmodul so zu steuern, dass dieses das Testsignal erzeugt und über die Hochfrequenzverbindung sendet, um das Detektionssignal zu erfassen, und abhängig vom Detektionssignal das erste Funkmodul (11) mit dem externen Steckverbinder (14) zu verbinden, wenn die externe Antenne an den externen Steckverbinder angeschlossen ist, und um das erste Funkmodul (11) mit der internen Antenne (13) zu verbinden, wenn die externe Antenne nicht an den externen Steckverbinder (14) angeschlossen ist.

2. Elektrische Ausrüstung nach Anspruch 1, bei der die Hochfrequenzverbindung (20) eine leitungsgebundene Verbindung ist.

3. Elektrische Ausrüstung nach Anspruch 1, bei der die Hochfrequenzverbindung eine gestrahlte Verbindung ist, wobei die Detektionsvorrichtung (55) eine Verbindungsantenne (56) umfasst, die über die Hochfrequenzverbindung mit einer Kommunikationsantenne (57) des zweiten Funkmoduls (52) verbunden ist.

4. Elektrische Ausrüstung nach einem der vorhergehenden Ansprüche, umfassend eine Haupthochfrequenzleitung (17), die eine Haupthochfrequenzspur (18) umfasst, die mit dem externen Steckverbinder (14) verbunden ist, wobei die Detektionsvorrichtung (26) eine Detektionshochfrequenzleitung (27) umfasst, die eine Detektionshochfrequenzspur (28) umfasst, die mit der Haupthochfrequenzspur (18) gekoppelt ist, und Detektionskomponenten, die mit der Detektionshochfrequenzspur (28) verbunden sind.

5. Elektrische Ausrüstung nach Anspruch 4, bei der die Detektionskomponenten erste Detektionskomponenten umfassen, die mit einem ersten Ende der Detektionshochfrequenzspur (28) verbunden und ausgebildet sind, um eine erste Spannung (V1) zu erzeugen, die repräsentativ für eine direkte Leistung ist, die direkt aus dem Senden des Testsignals (St) resultiert, zweite Detektionskomponenten, die mit einem zweiten Ende der Detektionshochfrequenzspur (28) verbunden und ausgebildet sind, um eine zweite Spannung (V2) zu erzeugen, die repräsentativ für eine reflektierte Leistung ist, die aus einer Reflexion des Testsignals (St) resultiert, wobei das Detektionssignal aus der ersten Spannung (V1) und der zweiten Spannung (V2) gewonnen wird.

6. Elektrische Ausrüstung nach Anspruch 5, bei der die ersten bzw. die zweiten Detektionskomponenten (29, 31) eine erste bzw. eine zweite Spannungserhöhungsschaltung umfassen, gefolgt von einer ersten bzw. einer zweiten Spitzendetektionsdiode (30, 32).

7. Elektrische Ausrüstung nach einem der Ansprüche 4 bis 6, bei der die Haupthochfrequenzleitung (17) eine Breitbandleitung ist, während die Detektionshochfrequenzleitung (27) eine auf eine Testfrequenz des Testsignals abgestimmte selektive Leitung ist.

8. Elektrische Ausrüstung nach einem der vorhergehenden Ansprüche, umfassend eine Schaltvorrichtung (21), wobei die Steuermittel ausgebildet sind, um die Schaltvorrichtung derart zu steuern, dass sie selektiv das zweite Funkmodul (12) mit dem externen Steckverbinder (14) verbindet oder von diesem trennt, und derart, dass sie selektiv das erste Funkmodul (11) mit der ersten internen Antenne (13) oder mit dem externen Steckverbinder (14) verbindet.

9. Elektrische Ausrüstung nach Anspruch 8, bei der die Schaltvorrichtung (21) einen ersten Zwei-Wege-Schalter (22) und einen zweiten Zwei-Wege-Schalter (23) umfasst, wobei der erste Zwei-Wege-Schalter einen ersten Eingang (E1) hat, der mit einem Ausgang (S2) des ersten Funkmoduls verbunden ist, einen zweiten Eingang (E2), der mit einem Ausgang (S1) des zweiten Funkmoduls über die Hochfrequenzverbindung (20) verbunden ist, wobei der zweite Zwei-Wege-Schalter einen Eingang (E3) hat, der mit einem Ausgang (S3) des ersten Zwei-Wege-Schalters verbunden ist, einen ersten Ausgang (S4), der mit der internen Antenne (13) verbunden ist, und einen zweiten Ausgang (S5), der mit dem externen Steckverbinder (14) verbunden ist.

10. Elektrische Ausrüstung nach einem der vorhergehenden Ansprüche, die so ausgebildet ist, dass eine Testfrequenz des Testsignals in einem Frequenzband enthalten ist, in dem das erste Funkmodul (11) arbeitet.

11. Elektrische Ausrüstung nach einem der vorhergehenden Ansprüche, die so ausgebildet ist, dass das Testsignal derart kodiert ist, dass vermieden wird, dass ein Störsignal bei der Testfrequenz die Detektionsvorrichtung (26) stört.

12. Elektrische Ausrüstung nach einem der vorhergehenden Ansprüche, bei der das erste Funkmodul ein zellulares Funkmodul ist und bei der das zweite Funkmodul ein ISM-Funkmodul ist.

13. Elektrische Ausrüstung nach einem der vorhergehenden Ansprüche, wobei die elektrische Ausrüstung ein Zähler ist.

14. Elektrische Ausrüstung nach einem der Ansprüche 1 bis 12, wobei die elektrische Ausrüstung ein Gateway ist.

15. Verfahren zur Detektion und zum Anschluss einer externen Antenne, das in einer elektrischen Ausrüstung nach einem der vorhergehenden Ansprüche durchgeführt wird, umfassend die Schritte:

  - Steuern des zweiten Funkmoduls (12) derart, dass dieses das Testsignal erzeugt und über die Hochfrequenzverbindung (20) an den externen Steckverbinder sendet;
  - Erfassen des Detektionssignals;
  - Ableiten aus dem Detektionssignal, ob die externe Antenne an den externen Steckverbinder angeschlossen ist oder nicht;
  - wenn die externe Antenne an den externen Steckverbinder angeschlossen ist, Anschließen des ersten Funkmoduls an den Steckverbinder;
  - andernfalls Anschließen des ersten Funkmoduls an die interne Antenne.

16. Computerprogramm, umfassend Anweisungen, die die elektrische Ausrüstung nach einem der Ansprüche 1 bis 14 veranlassen, die Schritte des Verfahrens zur Detektion und zum Anschluss der externen Antenne nach Anspruch 15 auszuführen.

17. Computerlesbarer Aufzeichnungsträger, auf dem das Computerprogramm nach Anspruch 16 gespeichert ist.

**Claims**

1. Electrical equipment comprising:

   • an internal antenna (13);
   • an external connector (14) arranged to be connected to an antenna external to the electrical equipment (10);
   • a first radio module (11);
   • a second radio module (12);

   each radio module being arranged to perform communication via a radio transmission

   • an RF link (20) connecting the second radio module to the external connector;
   • a detector device (26) arranged, when a test signal (St) is transmitted over the external connector via the RF link (20), to produce a detection signal representative of whether or not the external antenna is connected to the external connector;
   • control means (25) arranged to control the second radio module so that it generates and transmits the test signal via the RF link, to acquire the detection signal, and depending on the detection signal, to connect the first radio module (11) to the external connector (14) if the external antenna is connected to the external connector, or else to connect the first radio module (11) to the internal antenna (13) if the external antenna is not connected to the external connector (14).

2. Electrical equipment according to claim 1, wherein the RF link (20) is a conducted link.

3. Electrical equipment according to claim 1, wherein the RF link is a radiated link, the detector device (55) including a link antenna (56) connected by the RF link to a communication antenna (57) of the second radio module (52).

4. Electrical equipment according to any preceding claim, including a main RF transmission line (17) comprising a main RF track (18) connected to the external connector (14), the detector device (26) comprising a detector RF transmission line (27) comprising a detector RF track (28) coupled to the main RF track (18), and detector components connected to the detector RF track (28).

5. Electrical equipment according to claim 4, wherein the detector components comprise first detector components connected to a first end of the detector RF track (28) and arranged to produce a first voltage (V1) representative of a forward power resulting directly from transmission of the test signal (St), and second detector components connected to a second end of the detector RF track (28) and arranged to produce a second voltage (V2) representative of a reflected power resulting from reflection of the test signal (St), the detection signal being obtained from the first voltage (V1) and from the second voltage (V2).

6. Electrical equipment according to claim 5, wherein the first, respectively the second, detector components (29, 31) comprise respective a first, respectively a second, voltage boost circuits followed by a first, respectively a second, peak detector diodes (30, 32).

7. Electrical equipment according to any one of claims 4 to 6, wherein the main RF transmission line (17) is a wide band transmission line while the detector RF transmission line (27) is a selective transmission line tuned to a test frequency of the test signal.

8. Electrical equipment according to any preceding claim and including a switch device (21), the control means being arranged to control the switch device so as to connect or disconnect the second radio module (12) selectively to or from the external connector (14), and so as to connect the first radio module (11) selectively to the internal antenna (13) or to the external connector (14).

9. Electrical equipment according to claim 8, wherein the switch device (21) comprises a first double-throw switch (22) and a second double-throw switch (23), the first double-throw switch having a first input (E1) connected to an output (S2) of the first radio module and a second input (E2) connected to an output (S1) of the second radio module via the RF link (20), and the second double-throw switch having an input (E3) connected to an output (S3) of the first double-throw switch, a first output (S4) connected to the internal antenna (13), and a second output (S5) connected to the external connector (14).

10. Electrical equipment according to any preceding claim, arranged in such a manner that a test frequency of the test signal is included in a frequency band in which the first radio module (11) operates.

11. Electrical equipment according to any preceding claim, arranged in such a manner that the test signal is encoded so as to avoid an interfering signal at the test frequency disturbing the detector device (26).

12. Electrical equipment according to any preceding claim, wherein the first radio module is a cellular radio module and wherein the second radio module is an ISM radio module.

13. Electrical equipment according to any preceding claim, the electrical equipment being a meter.

14. Electrical equipment according to any one of claims 1 to 12, the electrical equipment being a gateway.

15. A method of detecting and connecting an external antenna, the method being performed in electrical equipment according to any preceding claim and comprising the steps of:

> • controlling the second radio module (12) so that it generates and transmits the test signal over the external connector via the RF link (20);
> • acquiring the detection signal;
> • deducing from the detection signal whether or not the external antenna is connected to the external connector;
> • if the external antenna is connected to the external connector, connecting the first radio module to the connector; or else
> • connecting the first radio module to the internal antenna.

16. A computer program including instructions for causing the electrical equipment according to any one of claims 1 to 14 to execute the steps of the method of detecting and connecting an external antenna according to claim 15.

17. A computer readable storage medium having stored thereon the computer program according to claim 16.

EP 3 840 113 B1

Fig. 1

2

4

6

5

3

1

Fig. 2

-11-

S2

22

23

16

13

E1
St
S3
S4

E2
E3
S5

14

20

17

St

-12-

S1

21

St

10

-25-

Fig. 3

Fig. 4

Fig. 5

Fig. 6

Fig. 7

Fig. 8

Fig. 9

Fig. 10

Fig. 11

C0 C1 C2 C3 C4 C5 C6 C7 C8 C9 C10 C11 C12 C13 C14 C15 C16

| Pin(1) | TOS = 1 (P1) Z2= 50 Ohms | | TOS = 1 (P2) Z1= 50 Ohms | | TOS = 2 | | | | TOS = 3 | | | | TOS = Infini | | | |
| | | | | | Z2= 25 Ohms | | Z2= 100 Ohms | | Z2= 16,5 Ohms | | Z2= 150 Ohms | | Z2= 0 Ohm | | Z2= Infini | |
| | V3 | V4 | V3 | V4 | V3 | V4 | V3 | V4 | V3 | V4 | V3 | V4 | V3 | V4 | V3 | V4 |
|---|---|---|---|---|---|---|---|---|---|---|---|---|---|---|---|---|
| -10 | 21 | 2 | 2 | 24 | 21 | 5 | 22 | 5 | 21 | 8 | 27 | 9 | 20 | 18 | 23 | 25 |
| -8 | 31 | 2 | 2 | 33 | 30 | 7 | 32 | 6 | 30 | 11 | 32 | 11 | 29 | 26 | 33 | 35 |
| -6 | 44 | 2 | 2 | 47 | 44 | 9 | 45 | 8 | 43 | 16 | 46 | 15 | 41 | 37 | 47 | 49 |
| -4 | 60 | 2 | 2 | 65 | 61 | 13 | 63 | 11 | 61 | 22 | 64 | 21 | 59 | 53 | 66 | 67 |
| -2 | 85 | 2 | 2 | 88 | 84 | 18 | 87 | 15 | 84 | 31 | 87 | 30 | 81 | 74 | 90 | 92 |
| 0 | 114 | 2 | 2 | 118 | 112 | 26 | 117 | 21 | 111 | 43 | 116 | 42 | 107 | 97 | 124 | 125 |
| 2 | 152 | 2 | 2 | 157 | 150 | 36 | 156 | 30 | 149 | 59 | 157 | 58 | 142 | 131 | 165 | 165 |
| 4 | 201 | 2 | 2 | 207 | 198 | 50 | 205 | 42 | 199 | 81 | 209 | 78 | 189 | 173 | 218 | 217 |
| 6 | 268 | 2 | 2 | 274 | 266 | 72 | 270 | 57 | 266 | 112 | 271 | 104 | 258 | 238 | 276 | 273 |
| 8 | 346 | 2 | 2 | 355 | 347 | 99 | 347 | 78 | 346 | 154 | 354 | 140 | 337 | 310 | 359 | 353 |
| 10 | 443 | 2 | 2 | 452 | 441 | 131 | 449 | 101 | 444 | 200 | 452 | 180 | 436 | 404 | 460 | 450 |

Fig. 12

**EP 3 840 113 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005094154 A2
- WO 2013089553 A1
- US 2018287657 A1
- WO 2019162432 A1